# EUROPÄISCHE PATENTSCHRIFT

(11) **EP 4 286 863 B1**
(45) Veröffentlichungstag und Bekanntmachung des Hinweises auf die Patenterteilung: **04.12.2024**
(21) Anmeldenummer: 23190758.5
(22) Anmeldetag: 08.10.2018
(51) Int. Cl.: G01R 1/04, H05K 5/00

(54) **MESSGERÄT ZUM MESSEN ELEKTRISCHER GRÖSSEN**
MEASURING DEVICE FOR MEASURING ELECTRICAL QUANTITIES
APPAREIL DE MESURE PERMETTANT DE MESURER DES GRANDEURS ÉLECTRIQUES

(30) Priorität: 20.10.2017 DE 102017124597
(43) Veröffentlichungstag der Anmeldung: 06.12.2023
(62) Teilanmeldung aus: 20173905.9
(73) Patentinhaber: Gossen Metrawatt GmbH, 90449 Nürnberg (DE)
(72) Erfinder: Weiß, Eike, 90419 Nürnberg (DE); Burger, Stefan, 90449 Nürnberg (DE); Fischer, Günther, 90449 Nürnberg (DE)
(74) Vertreter: Hafner & Kohl PartmbB

(56) Entgegenhaltungen:
- WO-A1-2009/126824
- DE-A1- 3 633 856
- US-A1- 2011 026 196
- GMC-I MESSTECHNIK GMBH: "METRALINE EXM25 Multimeter für den Einsatz in Ex-gefährdeten Bereichen", 1 October 2016 (2016-10-01), pages 1 - 4, XP055916780, Retrieved from the Internet <URL:https://www.gossenmetrawatt.de/media/doku/tx/metraline-exm25/metraline-exm25-db_d.pdf> [retrieved on 20220430]
- ANONYMOUS: "Metraline EXM25", GOSSEN METRAWATT, 1 January 2017 (2017-01-01), XP055532067

## Beschreibung

Die Erfindung betrifft ein Messgerät zum Messen elektrischer Größen, insbesondere elektrischer Spannungen und/oder elektrischer Ströme, umfassend einen einen Gehäuseraum umfassenden Gehäusekörper sowie wenigstens eine in dem Gehäuseraum angeordnete oder ausgebildete Messeinrichtung zur Messung einer mittels des Messgeräts messbaren bzw. zu messenden elektrischen Größe.

Derartige Messgeräte zum Messen elektrischer Größen, insbesondere elektrischer Spannungen und/oder elektrischer Ströme, sind aus dem Stand der Technik in unterschiedlichen Ausführungen, z. B. in Form von Multimetern, bekannt. Entsprechende Messgeräte können als stationäre oder als mobile bzw. portable Endgeräte ausgeführt sein.

Insbesondere für die Variante eines als mobiles bzw. portables Endgerät ausgeführten Messgeräts ist es bekannt, die für den Betrieb des Messgeräts bzw. entsprechender in dem Gehäuseraum eines messgeräteseitigen Gehäusekörpers angeordneter oder ausgebildeter messgeräteseitiger Messeinrichtungen erforderliche elektrische Energie über einen elektrischen Energiespeicher, d. h. typischerweise über einen elektrischen Akkumulator, kurz Akku, bereitzustellen. Der elektrische Energiespeicher ist hierzu in geeigneter Weise mit dem Gehäusekörper des Messgeräts zu verbinden, wobei eine Verbindung typischerweise eine elektrische wie auch mechanische Verbindung des elektrischen Energiespeichers mit dem Gehäusekörper des Messgeräts beinhaltet.

Bekannte Ansätze zur Realisierung einer entsprechenden Verbindung sind, insbesondere in funktioneller als auch konstruktiver Hinsicht, bisweilen aufwändig und wenig kompakt konzipiert, sodass ein Bedarf nach einem diesbezüglich verbesserten Messgerät besteht. Ähnliche Messgeräte wurden in WO 2009/126824 A1 und GMC-I Messtechnik Gmbh: "METRALINE EXM25 1-15 Multimeter für den Einsatz in Ex-gefährdeten Bereichen", am 1. Oktober 2016, in Seiten 1-4, offenbart.

Der Erfindung liegt demnach die Aufgabe zugrunde, ein Messgerät zum Messen elektrischer Größen anzugeben, welches eine, insbesondere in funktioneller als auch konstruktiver Hinsicht, verbesserte Verbindung messgeräteseitigen Gehäusekörpers mit einem elektrischen Energiespeicher ermöglicht.

Die Aufgabe wird durch ein Messgerät gemäß Anspruch 1 gelöst. Die hierzu abhängigen Ansprüche betreffen mögliche Ausführungsformen des Messgeräts.

Das hierin beschriebene Messgerät dient im Allgemeinen zum Messen elektrischer Größen bzw. Messgrößen, d. h. insbesondere elektrischer Ströme und/oder elektrischer Spannungen. Bei dem Messgerät kann es sich beispielsweise um ein bisweilen auch als Vielfachmessgerät bezeichnetes Multimeter handeln.

Das Messgerät umfasst einen in seiner räumlich-körperlichen Gestalt durch Wandungen bzw. Wandungsabschnitte definierten Gehäusekörper. Der Gehäusekörper kann ein- oder mehrteilig ausgeführt sein; in einer mehrteiligen Ausführung umfasst der Gehäusekörper mehrere Gehäusekörpersegmente, welche unter Ausbildung des Gehäusekörpers miteinander verbindbar bzw. verbunden sind. Unabhängig von der ein- oder mehrteiligen Ausführung umfasst der Gehäusekörper einen Gehäuseraum; hierbei handelt es sich typischerweise um ein durch entsprechende Wandungen bzw. Wandungsabschnitte des Gehäusekörpers begrenztes inneres Gehäusekörpervolumen. Der Gehäuseraum dient funktionell zumindest abschnittsweise als Aufnahmeraum zur Aufnahme diverser elektrischer bzw. elektronischer Bauteile bzw. Baugruppen des Messgeräts. In dem Gehäuseraum ist als Beispiel für ein(e) entsprechende(s) elektrische(s) bzw. elektronische(s) Bauteil bzw. Bauteilgruppe wenigstens eine Messeinrichtung zur Messung einer mittels des Messgeräts messbaren bzw. zu messenden elektrischen Größe, d. h. insbesondere zur Aufnahme und Verarbeitung einer mittels des Messgeräts messbaren bzw. zu messenden elektrischen Größe betreffender Messsignale, angeordnet oder ausgebildet. Die Messeinrichtung kann z. B. als hard- und/oder softwaremäßig implementierte Messelektronik ausgebildet sein bzw. eine solche umfassen.

Das Messgerät ist typischerweise als mobiles bzw. portables Endgerät ausgeführt.

Das Messgerät wird über einen elektrischen Energiespeicher (im Weiteren kurz als Energiespeicher bezeichnet), d. h. insbesondere einen wiederaufladbaren elektrischen Energiespeicher, wie z. B. einen elektrischen Akkumulator, kurz Akku, mit elektrischer Energie versorgt. Die für den Betrieb des Messgeräts bzw. elektrisch zu versorgender Komponenten des Messgeräts, d. h. insbesondere der in dem Gehäuseraum eines messgeräteseitigen Gehäusekörpers angeordneten oder ausgebildeten messgeräteseitigen Messeinrichtung, erforderliche elektrische Energie wird sonach über einen Energiespeicher bereitgestellt. Dem Messgerät ist demnach typischerweise wenigstens ein Energiespeicher zur elektrischen Versorgung des Messgeräts, insbesondere der Messeinrichtung, mit elektrischer Energie zugeordnet bzw. umfasst das Messgerät wenigstens einen Energiespeicher.

Um das Messgerät bzw. den Gehäusekörper mit einem entsprechenden Energiespeicher zu verbinden, weist der Gehäusekörper wenigstens einen Aufnahmebereich zur (beschädigungs- bzw. zerstörungsfrei) lösbaren Aufnahme eines Energiespeichers auf. Der Aufnahmebereich ist als schachtartig bzw. - förmig ausgebildete Ausnehmung in dem Gehäusekörper ausgebildet.

Unter einer schachtartig bzw. -förmigen Ausnehmung ist sowohl eine nur einseitig offene Ausführung des Aufnahmebereichs zu verstehen, als auch eine mehrseitig offene Ausführung des Aufnahmebereichs. Die als schachtartige bzw. -förmige Ausnehmung ausgebildete Ausführung des Aufnahmebereichs kann sonach darin bestehen, dass die Ausnehmung einseitig offen ist, d. h., dass der Gehäusekörper eine sich schachtartig bzw. -förmig in den bzw. durch den Gehäusekörper erstreckende kanalartige bzw. -förmige Öffnung aufweist, welche über einen (einzigen) Zugangsbereich zur (vollständigen) Aufnahme eines entsprechenden Energiespeichers eingerichtet ist. Von einem in einem entsprechend ausgeführten Aufnahmebereich aufgenommenen (im Wesentlichen quaderfömigen) Energiespeicher ist typischerweise nur eine Stirnseite sichtbar, alle anderen Seiten des Energiespeichers sind von dem Gehäusekörper umgeben bzw. umschlossen. Der Aufnahmebereich weist eine der, insbesondere rechteckförmigen, Querschnittsgeometrie des in diesem aufzunehmenden Energiespeichers gegengleiche Querschnittsgeometrie auf; ein entsprechend ausgeführter Aufnahmebereich weist typischerweise eine rechteckige Querschnittsgeometrie auf.

Die als schachtartige bzw. -förmige Ausnehmung ausgebildete Ausführung des Aufnahmebereichs kann jedoch auch darin bestehen, dass die Ausnehmung mehrseitig, d. h. insbesondere zweiseitig, offen ist, d. h., dass der Gehäusekörper eine sich schachtartig bzw. -förmig in den bzw. durch den Gehäusekörper erstreckende kanalartige bzw. -förmige Öffnung aufweist, welche über zwei Zugangsbereiche jeweils zur (vollständigen) Aufnahme eines entsprechenden Energiespeichers eingerichtet ist. Von einem in einem entsprechend ausgeführten Aufnahmebereich aufgenommenen Energiespeicher ist typischerweise eine Stirnseite und eine freiliegende Ober- bzw. Unterseite sichtbar, alle anderen Seiten des Energiespeichers sind von dem Gehäusekörper umgeben bzw. umschlossen. Auch in dieser Variante weist der Aufnahmebereich typischerweise eine der, insbesondere rechteckförmigen, Querschnittsgeometrie des in diesem aufzunehmenden Energiespeichers gegengleiche Querschnittsgeometrie auf; ein entsprechend ausgeführter Aufnahmebereich weist typischerweise eine (im Wesentlichen) U-förmige Querschnittsgeometrie auf.

In allen Fällen definiert der Aufnahmebereich sonach einen Aufnahmeraum, in welchem ein entsprechender Energiespeicher aufnehmbar und derart mit dem Energiespeicher verbindbar bzw. verbunden ist. Die schachtartige bzw. -förmige Ausführung des Aufnahmebereichs ermöglicht eine, insbesondere in funktioneller als auch konstruktiver Hinsicht, verbesserte Verbindung des Gehäusekörpers mit einem entsprechenden Energiespeicher.

Wie sich im Weiteren ergibt, ist ein in dem Aufnahmebereich bzw. -raum aufgenommener Energiespeicher typischerweise unverlierbar mit dem Gehäusekörper verbunden. Eine Verbindung des in dem Aufnahmebereich aufgenommenen Energiespeichers mit dem Gehäusekörper beinhaltet typischerweise eine elektrische Verbindung, d. h. eine elektrische Kontaktierung jeweiliger messgeräte- bzw. gehäusekörperseitiger elektrischer Anschlusselemente, als auch eine mechanische Verbindung des Energiespeichers mit dem Gehäusekörper.

Der Aufnahmebereich ist als Einschubbereich, in welchen ein in dem Aufnahmebereich aufzunehmender Energiespeicher einschiebbar ist, oder als Einsteckbereich, in welchen ein in dem Aufnahmebereich aufzunehmender Energiespeicher einsteckbar ist, ausgebildet. Die geometrisch-konstruktiven Abmessungen des Aufnahmebereichs sind in allen Fällen im Hinblick auf die geometrisch-konstruktiven Abmessungen eines in dem Aufnahmebereich aufzunehmenden Energiespeichers gewählt, sodass ein Einschieben bzw. Einstecken eines entsprechenden Energiespeichers sowie ein Entfernen eines in dem Aufnahmebereich aufgenommenen Energiespeichers aus dem Aufnahmebereich möglich ist. Typischerweise ist durch die schachtartige bzw. - förmige Gestalt des Aufnahmebereichs eine für einen Benutzer intuitiv erkennbare Einschiebe- bzw. Einsteckrichtung definiert, was die Handhabung des Messgeräts im Zusammenhang mit dem Ein- oder Ausbau eines Energiespeichers vereinfacht.

Der Aufnahmebereich kann, insbesondere im Hinblick auf die Abmessungen eines in diesem aufzunehmenden Energiespeichers, derart bemessen sein, dass ein in diesem aufgenommener Energiespeicher bündig mit den den Aufnahmebereich begrenzenden Wandungsabschnitten des Gehäusekörpers abschließend aufgenommen ist. Der in dem Aufnahmebereich aufgenommene Energiespeicher kann demnach bündig mit den den Aufnahmebereich begrenzenden Wandungsabschnitten des Gehäusekörpers abschließen. Die Abmessungen des Messgeräts verändern sich durch die Aufnahme eines Energiespeichers in dem gehäusekörperseitigen Aufnahmebereich sonach typischerweise nicht bzw. nur unwesentlich, was in einer kompakten Gestalt des Gehäusekörpers auch in dem Zustand, in dem ein Energiespeicher in dem gehäusekörperseitigen Aufnahmebereich aufgenommen ist, resultiert.

Der Aufnahmebereich kann z. B. im Bereich einer Rück- bzw. Unterseite des Gehäusekörpers ausgebildet sein. Als Rück- bzw. Unterseite des Gehäusekörpers ist typischerweise die Seite des Gehäusekörpers, welche einer mit wenigstens einem Anzeigeelement, d. h. z. B. einem Display, zur Anzeige von Informationen und/oder einem Bedienelement zur Bedienung des Messgeräts und/oder einem Messanschlusselement zum Anschluss einer Messkabels an das Messgerät ausgestatteten Seite des Gehäusekörpers gegenüber liegend angeordnet bzw. ausgebildet ist. Der Gehäusekörper kann sonach mit wenigstens einem Anzeigeelement zur Anzeige von Informationen und/oder einem Bedienelement zur Bedienung des Messgeräts ausgestattet sein.

Das Messgerät bzw. der Gehäusekörper kann eine Führungseinrichtung zur beweglichen Führung eines in dem Aufnahmebereich aufzunehmenden bzw. aufgenommenen Energiespeichers wenigstens zwischen einer ersten Führungsposition, insbesondere einer Führungsanfangsposition, und einer zweiten Führungsposition, insbesondere einer Führungsendposition umfassen. Eine entsprechende Führungseinrichtung ermöglicht eine stabile und zuverlässige Führung eines in dem Aufnahmebereich aufgenommenen Energiespeichers zwischen entsprechenden Führungspositionen und verbessert sonach die Handhabung des Messgeräts im Zusammenhang mit dem Ein- oder Ausbau eines Energiespeichers. Eine entsprechende zweite Führungsposition, d. h. insbesondere eine Führungsendposition, kann durch einen gehäusekörperseitig ausgebildeten oder angeordneten Anschlag definiert sein. Ein entsprechender Anschlag kann durch einen den Aufnahmebereich begrenzenden Wandungsabschnitt des Gehäusekörpers oder im Bereich eines den Aufnahmebereich begrenzenden Wandungsabschnitts des Gehäusekörpers angeordnet oder ausgebildet sein.

Die Führungseinrichtung kann wenigstens ein gehäusekörperseitig angeordnetes oder ausgebildetes erstes Führungselement und wenigstens ein energiespeicherseitig angeordnetes oder ausgebildetes zweites Führungselement umfassen, welche eingerichtet sind, unter Ausbildung der beweglichen Führung eines in dem Aufnahmebereich aufgenommenen Energiespeichers zusammenzuwirken. Entsprechende erste und zweite Führungselemente können formschlüssig zusammenwirken; bei entsprechenden Führungselementen kann es sich demnach etwa um korrespondierende Formschlusselemente, d. h. z. B. um Vorsprünge bzw. um hierzu korrespondierende Aufnahmen handeln.

Das Messgerät bzw. der Gehäusekörper kann alternativ oder ergänzend eine Sicherungseinrichtung zur Sicherung eines in dem Aufnahmebereich aufgenommenen Energiespeichers, insbesondere in einer Führungsendposition, gegenüber einer unerwünschten Bewegung des Energiespeichers aus dem Aufnahmebereich umfassen. Eine entsprechende Sicherungseinrichtung ermöglicht eine stabile und zuverlässige Aufnahme eines in dem Aufnahmebereich aufgenommenen Energiespeichers und verbessert sonach die Handhabung des Messgeräts; das Messgerät kann sonach, z. B. durch einen Benutzer, beliebig bewegt werden, ohne einen Verlust des Energiespeichers zu riskieren.

Die Sicherungseinrichtung kann wenigstens ein gehäusekörperseitig angeordnetes oder ausgebildetes erstes Sicherungselement und wenigstens ein energiespeicherseitig angeordnetes oder ausgebildetes zweites Sicherungselement umfassen, welche eingerichtet sind, unter Ausbildung der Sicherung eines in dem Aufnahmebereich aufgenommenen Energiespeichers zusammenzuwirken. Entsprechende erste und zweite Sicherungselemente können - analog jeweiligen ersten und zweiten Führungselementen (sofern vorhanden) - formschlüssig zusammenwirken; bei entsprechenden Führungselementen kann es sich demnach etwa um korrespondierende Formschlusselemente, d. h. z. B. um, z. B. hakenartige bzw. -förmige, Vorsprünge bzw. um hierzu korrespondierende Aufnahmen handeln. Gehäusekörperseitig ausgebildete erste Sicherungselemente können vermittels einer durch ein jeweiliges Federelement ausgeübten Federkraft in eine Sicherungsstellung federkraftbeaufschlagt sein, sodass eine Sicherung dadurch erfolgt, dass diese unter Ausbildung einer formschlüssigen Verbindung federkraftbeaufschlagt gegen die energiespeicherseitig ausgebildeten zweiten Sicherungselemente bewegt sind. Ein Lösen dieser formschlüssigen Verbindung kann durch Betätigen jeweiliger mit jeweiligen ersten Sicherungselementen gekoppelter Betätigungselemente entgegen der Federkraft erfolgen. Entsprechende Betätigungselemente können im Bereich des Gehäusekörpers angeordnet und relativ zu diesem zwischen wenigstens zwei Betätigungsstellungen, wobei wenigstens eine Betätigungsstellung in einem Lösen der formschlüssigen Verbindung resultiert, bewegbar gelagert sein.

Um eine Verbindung eines in dem Aufnahmebereich aufgenommenen Energiespeichers mit jeweiligen elektrisch zu versorgenden Komponenten des Messgeräts herzustellen, umfasst der Gehäusekörper ein einen Teil einer gehäusekörperseitigen elektrischen Anschlusseinrichtung bildendes elektrisches Anschlusselement, d. h. insbesondere einen elektrischen Kontakt, zum elektrischen Anschluss eines in dem Aufnahmebereich aufgenommenen Energiespeichers. Ein entsprechendes elektrisches Anschlusselement ist im Bereich des Aufnahmebereichs angeordnet oder ausgebildet. Derart kann sichergestellt werden, dass durch ordnungsgemäße Aufnahme eines Energiespeichers in dem Aufnahmebereich gleichermaßen eine elektrische Verbindung des Energiespeichers mit jeweiligen elektrisch zu versorgenden Komponenten des Messgeräts herstellbar bzw. hergestellt ist.

Ein entsprechendes elektrisches Anschlusselement kann insbesondere im Bereich eines den Aufnahmebereich begrenzenden Wandungsabschnitts des Gehäusekörpers angeordnet oder ausgebildet sein. Gemäß einer besonders zweckmäßigen Anordnung bzw. Ausbildung ist das elektrische Anschlusselement berührgeschützt innerhalb einer im Bereich eines den Aufnahmebereich begrenzenden Wandungsabschnitts des Gehäusekörpers vertieft ausgeführten ausgebildeten Ausnehmung angeordnet oder ausgebildet. Das elektrische Anschlusselement kann damit z. B. zurückversetzt gegenüber einem den Aufnahmebereich begrenzenden Wandungsabschnitt des Gehäusekörpers angeordnet oder ausgebildet sein, sodass ein Berühren des elektrischen Anschlusselements nicht möglich ist. Aus einer derartigen berührgeschützten (z. B. im Sinne der einschlägigen Normen für Berührschutz elektrischer bzw. elektronischer Geräte) Anordnung bzw. Ausbildung der gehäusekörperseitigen elektrischen Anschlusselemente ergeben sich erhebliche sicherheitstechnische Vorteile. Durch den Umstand, dass die gehäusekörperseitigen elektrischen Anschlusselemente berührgeschützt angeordnet sind, sind die elektrischen Anschlusselemente z. B. auch bei etwaigem Anliegen einer im Betrieb des Messgeräts anliegenden elektrischen Messspannung, d. h. z. B. einer Hochspannung, nicht berührbar. Entsprechend ist ein elektrisches Trennen des Messgeräts von einem Messkreis bei einem Wechsel eines Energiespeichers nicht (unbedingt) erforderlich.

Bezüglich des Energiespeichers ist ein einen Teil einer energiespeicherseitigen elektrischen Anschlusseinrichtung bildendes elektrisches Anschlusselement zum elektrischen Anschluss des in dem Aufnahmebereich aufgenommenen Energiespeichers an eine gehäusekörperseitige elektrische Anschlusseinrichtung bzw. ein dieser zugehöriges elektrisches Anschlusselement als ein von einem energiespeicherseitigen Gehäusekörper, insbesondere vorsprungartig bzw. -förmig, abragender Ansatz ausgebildet. Ein entsprechender Ansatz ist eingerichtet, im elektrisch mit einem einen Teil einer gehäusekörperseitigen elektrischen Anschlusseinrichtung bildenden gehäusekörperseitigen elektrischen Anschlusselement verbundenen Zustand in eine, wie beschriebene, im Bereich eines den gehäusekörperseitigen Aufnahmebereich begrenzenden Wandungsabschnitts des Gehäusekörpers ausgebildete Ausnehmung einzugreifen, in welcher Ausnehmung das einen Teil der gehäusekörperseitigen Anschlusseinrichtung bildende elektrische Anschlusselement angeordnet oder ausgebildet ist. Ein energiespeicherseitiges elektrisches Anschlusselement ist demnach, insbesondere in Längsrichtung bezüglich einer anschlusselementseitigen Längsachse, so bemessen, dass es jedenfalls mit einem entsprechend berührgeschützt ausgebildeten oder angeordneten gehäusekörperseitigen elektrischen Anschlusselement kontaktierbar ist. Das energiespeicherseitige elektrische Anschlusselement ist typischerweise derart isoliert, d. h. z. B. abschnittsweise von einem Isolationsmaterial umgeben, dass eine Berührung durch einen Benutzer nicht möglich ist.

Im Zusammenhang mit dem Energiespeicher ist ferner zu erwähnen, dass dieser, sofern als wiederaufladbarer Energiespeicher ausgeführt, mit einem weiteren elektrische Anschlusselement, hierbei kann es sich z. B. um einen USB-Anschluss, welcher mit einem Standard-USB-Ladekabel verbunden werden kann, versehen sein kann, über welches dieser im Rahmen eines Ladevorgangs mit einem Ladekabel oder dergleichen verbindbar ist. Dieses weitere Anschlusselement kann im Bereich einer Seite eines energiespeicherseitigen Gehäusekörpers angeordnet oder ausgebildet sein, welche im in dem gehäusekörperseitigen Aufnahmebereich aufgenommenen Zustand des Energiespeichers nicht zugänglich ist. Der Energiespeicher muss sonach aus dem Aufnahmebereich entnommen werden, um geladen werden zu können, was u.a. sicherheitsrelevante Vorteile mit sich bringt.

Um das Messgerät vor äußeren, d. h. insbesondere mechanischen, Einflüssen, wie z. B. unsachgemäße Handhabung, Stürze, etc., zu schützen, kann das Messgerät eine lösbar mit dem Gehäusekörper verbindbare oder verbundene, diesen im mit dem Gehäusekörper verbundenen Zustand zumindest abschnittsweise umgebende Schutzumhüllung zum Schutz des Gehäusekörpers vor äußeren Einflüssen umfassen. Die Schutzumhüllung kann aus einem mechanische Einflüsse absorbierenden bzw. dämpfenden Material, wie z. B. einem Elastomer- bzw. Gummimaterial, bzw. einer mechanische Einflüsse absorbierende bzw. dämpfende Materialstruktur, wie z. B. einer Schaum- bzw. Zellstruktur, gebildet sein.

Die Schutzumhüllung kann mit wenigstens einer Ausnehmung ausgebildet sein, durch welche ein in dem gehäusekörperseitigen Aufnahmebereich aufgenommener Energiespeicher aus dem Aufnahmebereich entnehmbar ist, oder ein in dem gehäusekörperseitigen Aufnahmebereich aufzunehmender Energiespeicher in den Aufnahmebereich einführbar ist. Derart ist ein Wechsel eines Energiespeichers auch möglich, wenn eine entsprechende Schutzumhüllung mit dem Gehäusekörper verbunden ist. Neben einer entsprechenden Ausnehmung für einen Energiespeicher kann die Schutzumhüllung auch mit wenigstens einer weiteren Ausnehmung, insbesondere für gehäusekörperseitig angeordnete oder ausgebildete Anzeige- und/oder Bedien- und/oder Messanschlusselemente, ausgebildet sein.

Die Erfindung ist anhand von Ausführungsbeispielen in den Zeichnungen näher erläutert. Dabei zeigen:
- Fig. 1 - 6: je eine Prinzipdarstellung eines Messgeräts gemäß einem Ausführungsbeispiel;
- Fig. 7, 8: je eine Prinzipdarstellung eines Messgeräts gemäß einem weiteren Ausführungsbeispiel; und
- Fig. 9, 10: je eine Prinzipdarstellung einer Schutzumhüllung gemäß einem Ausführungsbeispiel.

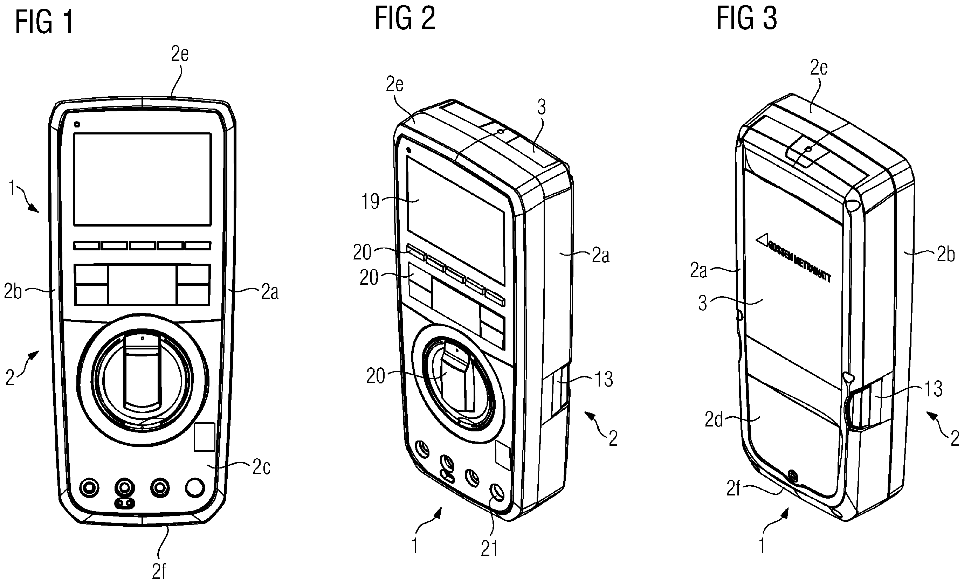

Die Fig. 1 - 6 zeigen je eine Prinzipdarstellung eines Messgeräts 1 gemäß einem ersten Ausführungsbeispiel; das Messgerät 1 ist in Fig. 1 in einer Frontansicht, in Fig. 2 in einer perspektivischen Ansicht auf die Vorderseite und in Fig. 3 in einer perspektivischen Ansicht auf die Rückseite dargestellt.

Das Messgerät 1 dient zum Messen elektrischer Größen bzw. Messgrößen, d. h. insbesondere elektrischer Ströme und/oder elektrischer Spannungen. Bei dem Messgerät 1 kann es sich beispielsweise um ein Multimeter handeln. Das Messgerät 1 ist als mobiles bzw. portables Endgerät ausgeführt.

Das Messgerät 1 umfasst einen in seiner räumlich-körperlichen Gestalt durch Wandungen 2a - 2f bzw. Wandungsabschnitte definierten Gehäusekörper 2. In den in den Fig. gezeigten Ausführungsbeispielen sind beispielhaft die Wandungen 2a - 2f bezeichnet, wobei die Wandungen 2a, 2b jeweils eine Seite des Gehäusekörpers 2 bildende seitliche Wandung, die Wandung 2c eine die Vorderseite des Gehäusekörpers 2 bildende vordere Wandung, die Wandung 2d eine die Hinter- bzw. Rückseite des Gehäusekörpers 2 bildende hintere Wandung, die Wandung 2e eine die Oberseite des Gehäusekörpers 2 bildende obere Wandung und die Wandung 2f eine die Unterseite des Gehäusekörpers 2 bildende untere Wandung bildet. Der Gehäusekörper 2 kann ein- oder mehrteilig ausgeführt sein; die Wandungen 2a - 2f können sonach Wandungsabschnitte eines einteilig ausgeführten Gehäusekörpers 2 oder jeweilige Gehäusekörpersegmente, welche unter Ausbildung des Gehäusekörpers 2 miteinander verbindbar bzw. verbunden sind, darstellen.

Der Gehäusekörper 2 umfasst einen Gehäuse(innen)raum (nicht näher gezeigt); hierbei handelt es sich um ein durch entsprechende Wandungen bzw. Wandungsabschnitte des Gehäusekörpers 2 begrenztes inneres Gehäusekörpervolumen. Der Gehäuseraum dient funktionell als Aufnahmeraum zur Aufnahme diverser elektrischer bzw. elektronischer Bauteile bzw. Baugruppen des Messgeräts 1. In dem Gehäuseraum ist eine Messeinrichtung (nicht gezeigt) zur Messung einer mittels des Messgeräts 1 messbaren bzw. zu messenden elektrischen Größe, d. h. insbesondere zur Aufnahme und Verarbeitung einer mittels des Messgeräts 1 messbaren bzw. zu messenden elektrischen Größe betreffender Messsignale, angeordnet oder ausgebildet.

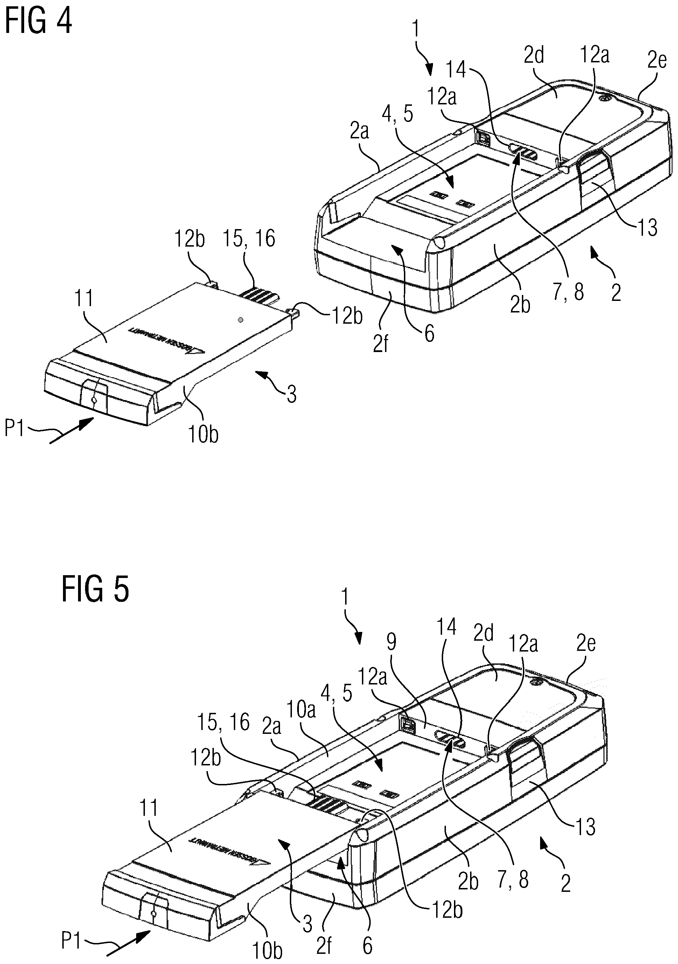

Dem Messgerät 1 ist ein Energiespeicher 3 (vgl. insbesondere Fig. 4 - 6), d. h. insbesondere ein wiederaufladbarer elektrischer Energiespeicher, wie z. B. ein elektrischer Akkumulator, zur elektrischen Versorgung des Messgeräts 1, insbesondere der Messeinrichtung, mit elektrischer Energie zugeordnet, über welchen das Messgerät 1 mit elektrischer Energie versorgt wird. Die für den Betrieb des Messgeräts 1 bzw. der Messeinrichtung erforderliche elektrische Energie wird sonach über den Energiespeicher 3 bereitgestellt.

Um das Messgerät 1 bzw. den Gehäusekörper 2 mit dem Energiespeicher 3 zu verbinden, weist der Gehäusekörper 2 einen Aufnahmebereich 4 zur (beschädigungs- bzw. zerstörungsfrei) lösbaren Aufnahme des Energiespeichers 3 auf. Der Aufnahmebereich 4 ist als schachtartig bzw. -förmig ausgebildete Ausnehmung 5 in dem Gehäusekörper 2 ausgebildet (vgl. insbesondere Fig. 4 - 6). Der Aufnahmebereich 4 ist in den in den Fig. gezeigten Ausführungsbeispielen im Bereich der Rückseite des Gehäusekörpers 2 ausgebildet.

Die schachtartige bzw. -förmige Ausnehmung 5 ausgebildete Ausführung des Aufnahmebereichs 4 besteht in den in den Fig. gezeigten Ausführungsbeispielen darin, dass die Ausnehmung 5 mehrseitig, d. h. zweiseitig, offen ist, d. h., dass der Gehäusekörper 2 eine sich schachtartig bzw. -förmig in den bzw. durch den Gehäusekörper 2 erstreckende kanalartige bzw. -förmige Öffnung 6 aufweist. Anhand der Fig. 2, 3 ist ersichtlich, dass von dem in dem Aufnahmebereich 4 aufgenommenen Energiespeicher 3 eine Stirnseite und eine Oberseite freiliegt und somit sichtbar ist, alle anderen Seiten des Energiespeichers 3 sind von dem Gehäusekörper 2 umgeben bzw. umschlossen. Anhand der Fig. 4 - 6 ist ersichtlich, dass der Aufnahmebereich 4 eine der (im Wesentlichen) quaderförmigen Querschnittsgeometrie des Energiespeichers 3 gegengleiche Querschnittsgeometrie aufweist; konkret weist der Aufnahmebereich 4 in den in den Fig. gezeigten Ausführungsbeispielen eine (im Wesentlichen) U-förmige Querschnittsgeometrie auf.

Der in dem Aufnahmebereich 4 aufgenommene Energiespeicher 3 ist unverlierbar mit dem Gehäusekörper 2 verbunden. Eine Verbindung des in dem Aufnahmebereich 4 aufgenommenen Energiespeichers 3 mit dem Gehäusekörper 2 beinhaltet eine elektrische Verbindung, d. h. eine elektrische Kontaktierung jeweiliger messgeräte- bzw. gehäusekörperseitiger elektrischer Anschlusselemente 7, als auch eine mechanische Verbindung des Energiespeichers 3 mit dem Gehäusekörper 2.

Der Aufnahmebereich 4 ist in den Fig. gezeigten Ausführungsbeispielen als Einsteck- bzw. Einschubbereich, in welchen der in dem Aufnahmebereich 4 aufzunehmende Energiespeicher 3 einsteck- bzw. einschiebbar ist, ausgebildet.

Die geometrisch-konstruktiven Abmessungen des Aufnahmebereichs 4 sind demnach im Hinblick auf die geometrisch-konstruktiven Abmessungen des in dem Aufnahmebereich 4 aufzunehmenden Energiespeichers 3 gewählt, sodass ein Einstecken bzw. Einschieben des Energiespeichers 3 sowie ein Entfernen des in dem Aufnahmebereich 4 aufgenommenen Energiespeichers 3 aus dem Aufnahmebereich 4 möglich ist (vgl. Fig. 4 - 6). Das Einstecken bzw. Einschieben des Energiespeichers 3 ist in den Fig. 4 - 6 durch den Pfeil P1 angedeutet.

Der Aufnahmebereich 4 ist im Hinblick auf die Abmessungen des in diesem aufzunehmenden Energiespeichers 3 derart bemessen, dass der in diesem aufgenommene Energiespeicher 3 bündig mit den den Aufnahmebereich 4 begrenzenden Wandungsabschnitten des Gehäusekörpers 2 abschließend aufgenommen ist (vgl. z. B. Fig. 3). Der in dem Aufnahmebereich 4 aufgenommene Energiespeicher 3 schließt demnach bündig mit den den Aufnahmebereich 4 begrenzenden Wandungsabschnitten des Gehäusekörpers 2 ab.

Das Messgerät 1 umfasst in den in den Fig. gezeigten Ausführungsbeispielen eine Führungseinrichtung 10 zur beweglichen Führung des in dem Aufnahmebereich 4 aufgenommenen Energiespeichers 3 zwischen einer ersten Führungsposition, insbesondere einer in Fig. 5 gezeigten Führungsanfangsposition, und einer zweiten Führungsposition, insbesondere einer z. B. in den Fig. 2, 3 gezeigten Führungsendposition, und umgekehrt. Ersichtlich ist die zweite Führungsposition, d. h. die Führungsendposition, durch einen gehäusekörperseitig ausgebildeten Anschlag definiert. Der Anschlag ist durch einen den Aufnahmebereich 4 begrenzenden, quer bezüglich der Längsachse des Gehäusekörpers 2 verlaufenden Wandungsabschnitt 9 des Gehäusekörpers 2 ausgebildet.

Die Führungseinrichtung 10 umfasst gehäusekörperseitig ausgebildete erste Führungselemente 10a, welche in den in den Fig. gezeigten Ausführungsbeispielen durch den Aufnahmebereich 4 begrenzende Wandungsabschnitte des Gehäusekörpers 2 gebildet sind, und energiespeicherseitig ausgebildete zweite Führungselemente 10b, welche in den in den Fig. gezeigten Ausführungsbeispielen durch einen Gehäusekörper 11 des Energiespeichers 3 seitlich begrenzende Wandungsabschnitte ausgebildet sind. Die Führungselemente 10a, 10b sind eingerichtet, unter Ausbildung der beweglichen Führung des in dem Aufnahmebereich 4 aufzunehmenden bzw. aufgenommenen Energiespeichers 3 formschlüssig zusammenzuwirken; bei entsprechenden Führungselementen 10a, 10b kann es sich, wenngleich in den Fig. nicht gezeigt, um korrespondierende Formschlusselemente, d. h. z. B. um Vorsprünge bzw. um hierzu korrespondierende Aufnahmen handeln.

Das Messgerät 1 umfasst ferner eine Sicherungseinrichtung 12 zur Sicherung des in dem Aufnahmebereich 4 aufgenommenen Energiespeichers 3, insbesondere in der Führungsendposition, gegenüber einer unerwünschten Bewegung des Energiespeichers 3 aus dem Aufnahmebereich 4.

Die Sicherungseinrichtung 12 umfasst gehäusekörperseitig ausgebildete erste Sicherungselemente 12a, welche in den in den Fig. gezeigten Ausführungsbeispielen durch Formschlusselemente in Form von Aufnahmeöffnungen im Bereich der den Aufnahmebereich 4 begrenzenden Wandungsabschnitte des Gehäusekörpers 2 gebildet sind, und energiespeicherseitig ausgebildete zweite Sicherungselemente 12b, welche in den in den Fig. gezeigten Ausführungsbeispielen durch Formschlusselemente in Form von von dem Gehäusekörper 11 des Energiespeichers 3 in Längsrichtung abragende hakenartige bzw. -förmige Vorsprünge gebildet sind. Die Sicherungselemente 12a, 12b sind eingerichtet, unter Ausbildung der Sicherung des in dem Aufnahmebereich 4 aufgenommenen Energiespeichers 3 formschlüssig zusammenzuwirken. Die gehäusekörperseitig ausgebildeten ersten Sicherungselemente 12a können vermittels einer durch ein jeweiliges Federelement (nicht gezeigt) ausgeübten Federkraft in Sicherungsstellung federkraftbeaufschlagt sein, sodass eine Sicherung dadurch erfolgt, dass diese unter Ausbildung einer formschlüssigen Verbindung federkraftbeaufschlagt gegen die energiespeicherseitig ausgebildeten zweiten Sicherungselemente 12b bewegt sind. Ein Lösen dieser formschlüssigen Verbindung ist in den in den Fig. gezeigten Ausführungsbeispielen durch Betätigen jeweiliger mit jeweiligen ersten Sicherungselementen 12a gekoppelten Betätigungselementen 13 entgegen der Federkraft möglich. Die Betätigungselemente 13 sind in den in den Fig. gezeigten Ausführungsbeispielen im Bereich des Gehäusekörpers 2 angeordnet und relativ zu diesem zwischen wenigstens zwei Betätigungsstellungen, wobei wenigstens eine Betätigungsstellung in einem Lösen der formschlüssigen Verbindung resultiert, bewegbar gelagert.

Um eine Verbindung eines in dem Aufnahmebereich 4 aufgenommenen Energiespeichers 3 mit jeweiligen elektrisch zu versorgenden Komponenten des Messgeräts 1 herzustellen, umfasst der Gehäusekörper 2 das einen Teil einer gehäusekörperseitigen elektrischen Anschlusseinrichtung 8 bildende elektrische Anschlusselement 7, d. h. insbesondere einen elektrischen Kontakt. Das elektrische Anschlusselement 7 ist im Bereich des Aufnahmebereichs 4 angeordnet. Mithin ist durch ordnungsgemäße Aufnahme des Energiespeichers 3 in dem Aufnahmebereich 4 eine elektrische Verbindung des Energiespeichers 3 mit jeweiligen elektrisch zu versorgenden Komponenten des Messgeräts 1 herstellbar bzw. hergestellt.

Anhand der Fig. 4 - 6 ist ersichtlich, dass das elektrische Anschlusselement 7 im Bereich eines den Aufnahmebereich 4 begrenzenden Wandungsabschnitts 9 des Gehäusekörpers 2 angeordnet ist. Konkret ist das elektrische Anschlusselement 7 in den in den Fig. gezeigten Ausführungsbeispielen berührgeschützt innerhalb einer im Bereich des den Aufnahmebereich 4 begrenzenden Wandungsabschnitts 9 in einem bezüglich einer den Aufnahmebereich 4 begrenzenden Wandungsabschnitt 9 vertieft ausgeführten Ausnehmung 14 angeordnet. Das elektrische Anschlusselement 7 ist damit zurückversetzt gegenüber dem den Aufnahmebereich 4 begrenzenden Wandungsabschnitt 9 angeordnet, sodass ein Berühren des elektrischen Anschlusselements 7 nicht möglich ist. Durch den Umstand, dass das gehäusekörperseitige elektrische Anschlusselement 7 berührgeschützt angeordnet ist, ist das elektrische Anschlusselement 7 z. B. auch bei etwaigem Anliegen einer im Betrieb des Messgeräts 1 anliegenden elektrischen Messspannung, d. h. z. B. einer Hochspannung, nicht berührbar. Entsprechend ist ein elektrisches Trennen des Messgeräts 1 von einem Messkreis bei einem Wechsel des Energiespeichers 3 nicht (unbedingt) erforderlich.

Anhand der Fig. 4 - 6 ist weiter ersichtlich, dass ein einen Teil einer energiespeicherseitigen elektrischen Anschlusseinrichtung 15 bildendes elektrisches Anschlusselement 16 zum elektrischen Anschluss des in dem Aufnahmebereich 4 aufgenommenen Energiespeichers 3 an die gehäusekörperseitige elektrische Anschlusseinrichtung 8 bzw. das dieser zugehöriges elektrische Anschlusselement 7 als ein von dem energiespeicherseitigen Gehäusekörper 11 vorsprungartig bzw. -förmig abragender Ansatz ausgebildet ist. Ein entsprechender Ansatz ist eingerichtet, im elektrisch mit dem gehäusekörperseitigen elektrischen Anschlusselement 7 verbundenen Zustand, in die im Bereich des den Aufnahmebereich 4 begrenzenden Wandungsabschnitts 9 ausgebildete Ausnehmung 14, in welcher Ausnehmung 14 das elektrische Anschlusselement 7 angeordnet ist, einzugreifen. Das energiespeicherseitige elektrische Anschlusselement 16 ist demnach, insbesondere in Längsrichtung bezüglich einer anschlusselementseitigen Längsachse, so bemessen, dass es jedenfalls mit dem berührgeschützt angeordneten gehäusekörperseitigen elektrischen Anschlusselement 7 kontaktierbar ist. Das energiespeicherseitige elektrische Anschlusselement 16 ist typischerweise derart isoliert, dass eine Berührung durch einen Benutzer nicht möglich ist.

Der Energiespeicher 3 ist mit einem weiteren elektrischen Anschlusselement (nicht gezeigt), hierbei kann es sich z. B. um einen USB-Anschluss, welcher mit einem Standard-USB-Ladekabel verbunden werden kann, versehen, über welches dieser im Rahmen eines Ladevorgangs mit einem Ladekabel oder dergleichen verbindbar ist. Dieses weitere Anschlusselement ist im Bereich einer Seite des energiespeicherseitigen Gehäusekörpers 11 angeordnet oder ausgebildet, welche im in dem Aufnahmebereich 4 aufgenommenen Zustand des Energiespeichers 3 nicht zugänglich ist; das weitere elektrische Anschlusselement ist deshalb in den Fig. nicht zu sehen. Der Energiespeicher 3 muss sonach aus dem Aufnahmebereich 4 entnommen werden, um geladen werden zu können, was sicherheitsrelevante Vorteile mit sich bringt.

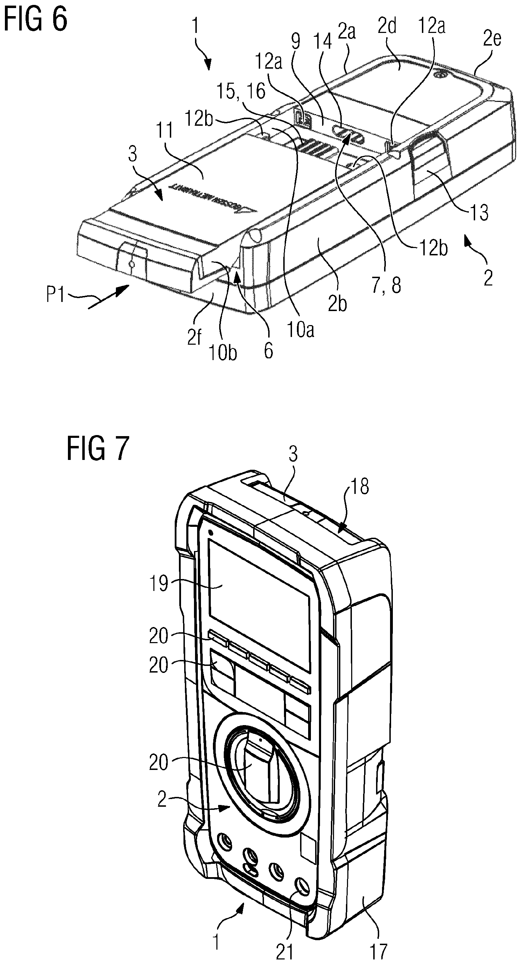

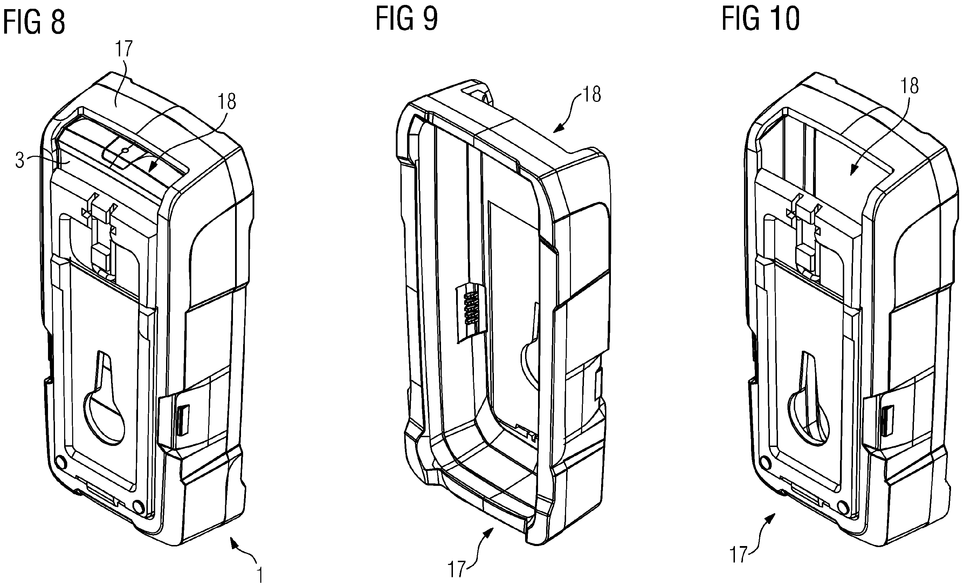

Die Fig. 7, 8 zeigen je eine Prinzipdarstellung eines Messgeräts 1 gemäß einem mit dem ersten Ausführungsbeispiel kombinierbaren zweiten Ausführungsbeispiel; das Messgerät 1 ist in Fig. 7 in einer perspektivischen Ansicht auf die Vorderseite und in Fig. 8 in einer perspektivischen Ansicht auf die Rückseite dargestellt. Die Fig. 8, 9 zeigen je eine Prinzipdarstellung einer Schutzumhüllung 17; die Schutzumhüllung 17 ist in Fig. 9 in einer perspektivischen Ansicht auf die Vorderseite und in Fig. 10 in einer perspektivischen Ansicht auf die Rückseite dargestellt.

Die Schutzumhüllung 17 dient dazu, das Messgerät 1 vor äußeren, d. h. insbesondere mechanischen, Einflüssen, wie z. B. unsachgemäße Handhabung, Stürzen, etc., zu schützen. Die Schutzumhüllung 17 ist lösbar mit dem Gehäusekörper 2 des Messgeräts 1 verbindbar bzw. verbunden (vgl. Fig. 7, 8) und umgibt diesen im mit dem Gehäusekörper 2 verbundenen Zustand abschnittsweise. Die Schutzumhüllung 17 ist aus einem mechanische Einflüsse absorbierenden bzw. dämpfenden Material, wie z. B. einem Elastomer- bzw. Gummimaterial, bzw. einer mechanische Einflüsse absorbierende bzw. dämpfende Materialstruktur, wie z. B. einer Schaum- bzw. Zellstruktur, gebildet.

Anhand der Fig. 7 - 10 ist ersichtlich, dass die Schutzumhüllung 17 mit einer Ausnehmung 18 ausgebildet ist, durch welche ein in dem gehäusekörperseitigen Aufnahmebereich 4 aufgenommener Energiespeicher 3 aus dem Aufnahmebereich 4 entnehmbar ist, bzw. ein in dem gehäusekörperseitigen Aufnahmebereich 4 aufzunehmender Energiespeicher 3 in den Aufnahmebereich 4 einführbar ist. Derart ist ein Wechsel eines Energiespeichers 3 auch möglich, wenn die Schutzumhüllung 17 mit dem Gehäusekörper 2 verbunden ist. Neben einer entsprechenden Ausnehmung 18 für den Energiespeicher 3 ist die Schutzumhüllung 17 auch mit wenigstens eine weitere Ausnehmung, insbesondere für gehäusekörperseitig angeordnete oder ausgebildete Anzeigeelemente 19, Bedienelemente 20 oder Messanschlusselemente 21 ausgebildet.

## Patentansprüche

1. Messgerät (1) zum Messen elektrischer Größen, insbesondere elektrischer Spannungen und/oder elektrischer Ströme, umfassend:
- einen einen Gehäuseraum umfassende Gehäusekörper (2),
- wenigstens eine in dem Gehäuseraum angeordnete oder ausgebildete Messeinrichtung zur Messung einer mittels des Messgeräts (1) messbaren elektrischen Größe, sowie
- einen elektrischen Energiespeicher (3), wobei der Gehäusekörper (2) wenigstens einen Aufnahmebereich (4) zur lösbaren Aufnahme des elektrischen Energiespeichers (3) aufweist, wobei der Aufnahmebereich (4) als schachtartig bzw. -förmig ausgebildete Ausnehmung (5) in dem Gehäusekörper (2) ausgebildet ist, wobei der elektrische Energiespeicher (3) ein einen Teil einer energiespeicherseitigen elektrischen Anschlusseinrichtung (15) bildendes elektrisches Anschlusselement (16) zum elektrischen Anschluss des in dem Aufnahmebereich (4) aufgenommenen elektrischen Energiespeichers (3) an ein einer gehäusekörperseitigen elektrischen Anschlusseinrichtung (8) zugehöriges elektrisches Anschlusselement (7) umfasst und das energiespeicherseitige Anschlusselement (16) als ein von einem energiespeicherseitigen Gehäusekörper (11) abragender Ansatz ausgebildet ist,
**dadurch gekennzeichnet, dass**
der elektrische Energiespeicher (3) mit einem weiteren elektrischen Anschlusselement versehen ist, über welches dieser im Rahmen eines Ladevorgangs mit einem Ladekabel oder dergleichen verbindbar ist, wobei dieses weitere Anschlusselement im Bereich einer Seite eines energiespeicherseitigen Gehäusekörpers (11) angeordnet oder ausgebildet ist, welche im in dem Aufnahmebereich (4) aufgenommenen Zustand des Energiespeichers (3) nicht zugänglich ist.

2. Messgerät nach Anspruch 1, **dadurch gekennzeichnet, dass** der Aufnahmebereich (4) als Einschubbereich, in welchen ein in dem Aufnahmebereich aufzunehmender elektrischer Energiespeicher (3) einschiebbar ist, oder als Einsteckbereich, in welchen ein in dem Aufnahmebereich (4) aufzunehmender elektrischer Energiespeicher (3) einsteckbar ist, ausgebildet ist.

3. Messgerät nach einem der vorhergehenden Ansprüche, **dadurch gekennzeichnet, dass** der Aufnahmebereich (4), insbesondere im Hinblick auf die Abmessungen eines in diesem aufzunehmenden elektrischen Energiespeichers (3), derart bemessen ist, dass ein in diesem aufgenommener elektrischer Energiespeicher (3) bündig mit den den Aufnahmebereich (4) begrenzenden Wandungsabschnitten des Gehäusekörpers (2) abschließend aufgenommen ist.

4. Messgerät nach einem der vorhergehenden Ansprüche, **dadurch gekennzeichnet, dass** der Aufnahmebereich (4) eine der, insbesondere rechteckförmigen, Querschnittsgeometrie des in diesem aufzunehmenden elektrischen Energiespeichers (3) gegengleiche, insbesondere U-förmige, Querschnittsgeometrie aufweist.

5. Messgerät nach einem der vorhergehenden Ansprüche, **dadurch gekennzeichnet, dass** der Aufnahmebereich (4) im Bereich einer Rück- bzw. Unterseite des Gehäusekörpers (2) ausgebildet ist.

6. Messgerät nach einem der vorhergehenden Ansprüche, **gekennzeichnet durch** eine Führungseinrichtung (10) zur beweglichen Führung eines in dem Aufnahmebereich (4) aufgenommenen elektrischen Energiespeichers (3) wenigstens zwischen einer ersten Führungsposition, insbesondere einer Führungsanfangsposition, und einer zweiten Führungsposition, insbesondere einer Führungsendposition.

7. Messgerät nach Anspruch 6, **dadurch gekennzeichnet, dass** die Führungseinrichtung (10) wenigstens ein gehäusekörperseitig angeordnetes oder ausgebildetes erstes Führungselement (10a) und wenigstens ein energiespeicherseitig angeordnetes oder ausgebildetes zweites Führungselement (10b) umfasst, welche eingerichtet sind, unter Ausbildung der beweglichen Führung eines in dem Aufnahmebereich (4) aufgenommenen elektrischen Energiespeichers (3) zusammenzuwirken.

8. Messgerät nach einem der vorhergehenden Ansprüche, **gekennzeichnet durch** eine Sicherungseinrichtung (12) zur Sicherung eines in dem Aufnahmebereich (4) aufgenommenen elektrischen Energiespeichers (3), insbesondere in einer Führungsendposition, gegenüber einer unerwünschten Bewegung des elektrischen Energiespeichers (3) aus dem Aufnahmebereich (4).

9. Messgerät nach Anspruch 8, **dadurch gekennzeichnet, dass** die Sicherungseinrichtung (12) wenigstens ein gehäusekörperseitig angeordnetes oder ausgebildetes erstes Sicherungselement (12a) und wenigstens ein energiespeicherseitig angeordnetes oder ausgebildetes zweites Sicherungselement (12b) umfasst, welche eingerichtet sind, unter Ausbildung der Sicherung eines in dem Aufnahmebereich (4) aufgenommenen elektrischen Energiespeichers (3) zusammenzuwirken.

10. Messgerät nach einem der vorhergehenden Ansprüche, **dadurch gekennzeichnet, dass** im Bereich des Aufnahmebereichs (4) wenigstens ein einen Teil einer gehäusekörperseitigen elektrischen Anschlusseinrichtung (8) bildendes elektrisches Anschlusselement (7) zum elektrischen Anschluss eines in dem Aufnahmebereich (4) aufgenommenen elektrischen Energiespeichers (3) angeordnet oder ausgebildet ist.

11. Messgerät nach Anspruch 10, **dadurch gekennzeichnet, dass** das elektrische Anschlusselement (7) im Bereich eines den Aufnahmebereich (4) begrenzenden Wandungsabschnitts (9) des Gehäusekörpers (2) angeordnet oder ausgebildet ist.

12. Messgerät nach Anspruch 9 oder 10, **dadurch gekennzeichnet, dass** das elektrische Anschlusselement (7) berührgeschützt innerhalb einer im Bereich eines den Aufnahmebereich (4) begrenzenden Wandungsabschnitts (9) des Gehäusekörpers (2), insbesondere in einem bezüglich einer den Aufnahmebereich (4) begrenzenden Wandungsabschnitt (9) des Gehäusekörpers (2) zurückversetzten, ausgebildeten Ausnehmung angeordnet oder ausgebildet ist.

13. Messgerät nach einem der vorhergehenden Ansprüche, **gekennzeichnet durch** eine lösbar mit dem Gehäusekörper (2) verbindbare oder verbundene, diesen im mit dem Gehäusekörper (2) verbundenen Zustand zumindest abschnittsweise umgebende Schutzumhüllung (17) zum Schutz des Gehäusekörpers (2) vor äußeren Einflüssen.

## Claims

1. Measuring instrument (1) for measuring electrical quantities, in particular electrical voltages and/or electrical currents, comprising:
- a housing body comprising a housing space (2),
- at least one measuring device arranged or formed in the housing space for measuring an electrical quantity measurable by means of the measuring instrument (1), and
- an electrical energy storage (3), wherein the housing body (2) has at least one receiving region (4) for releasable receiving of the electrical energy storage (3), wherein the receiving region (4) is formed as a slot-like or -shaped recess (5) in the housing body (2), wherein the electrical energy storage (3) comprises a part of an energy storage-side electrical connection device (15) forming an electrical connection element (16) for the electrical connection of the electrical energy storage (3) received in the receiving region (4) to an electrical connection element (8) associated with a housing-side electrical connection device (8) and the energy storage-side connection element (16) is formed as a projection from an energy storage-side housing body (11),
**characterized by the fact that**
The electrical energy storage (3) is provided with a further electrical connection element via which it can be connected to a charging cable or the like in the context of a charging process, wherein this further connection element is arranged or formed in the region of one side of an energy storage side housing body (11), which is not accessible in the receiving region (4) in the state of the energy storage (3).

2. Measuring instrument according to claim 1, **characterized in that** the receiving region (4) is designed as an insertion region in which an electrical energy storage (3) to be received in the receiving region can be inserted, or as a plug-in region in which an electrical energy storage (3) to be received in the receiving region (4) can be inserted.

3. Measuring instrument according to one of the preceding claims, **characterized in that** the receiving region (4), in particular with regard to the dimensions of an electrical energy storage device (3) to be received in this, is dimensioned such that an electrical energy storage device (3) received in this is conclusively received flush with the wall portions of the housing body (2) limiting the receiving region (4).

4. Measuring instrument according to one of the preceding claims, **characterized in that** the receiving region (4) has one of the, in particular rectangular, cross-sectional geometry of the electrical energy storage (3) to be received in this opposite, in particular U-shaped, cross-sectional geometry.

5. Measuring instrument according to one of the preceding claims, **characterized in that** the receiving region (4) is formed in the region of a back or bottom of the housing body (2).

6. Measuring instrument according to one of the preceding claims, **characterized by** a guide means (10) for movable guidance of an electrical energy storage (3) received in the receiving region (4) at least between a first guide position, in particular a guide initial position, and a second guide position, in particular a guide end position.

7. Measuring instrument according to claim 6, **characterized in that** the guide means (10) comprises at least one housing-side arranged or formed first guide element (10a) and at least one energy storage-side arranged or formed second guide element (10b), which are arranged to interact with forming the movable guide of an electrical energy storage (3) received in the receiving region (4).

8. Measuring instrument according to one of the preceding claims, **characterized by** a securing device (12) for securing an electrical energy storage device (3) received in the receiving region (4), in particular in a guide end position, against undesirable movement of the electrical energy storage device (3) from the receiving region (4).

9. Measuring instrument according to claim 8, **characterized in that** the securing device (12) comprises at least one housing-side arranged or formed first securing element (12a) and at least one energy storage-side arranged or formed second securing element (12b), which are arranged to act together forming the securing of an electrical energy storage (3) received in the receiving region (4).

10. Measuring instrument according to one of the preceding claims, **characterized in that** in the region of the receiving region (4) at least one part of a housing-side electrical connection device (8) forming electrical connection element (7) for the electrical connection of an electrical energy storage (3) received in the receiving region (4) is arranged or formed.

11. Measuring instrument according to claim 10, **characterized in that** the electrical connection element (7) is arranged or formed in the region of a wall portion (9) of the housing body (2) limiting the receiving region (4).

12. Measuring instrument according to claim 9 or 10, **characterized in that** the electrical connection element (7) is contact-protected within a wall portion (9) of the housing body (9) limiting in the region of the receiving region (4), in particular in a recess (9) of the housing body (2) recessed, formed or formed with respect to a wall portion (9) limiting the receiving region (4).

13. Measuring instrument according to one of the preceding claims, **characterized by** a detachable with the housing body (2) connectable or connected, this in the connected to the housing body (2) state at least partially surrounding protective coating (17) for the protection of the housing body (2) from external influences.

## Revendications

1. Appareil de mesure (1) pour la mesure de grandeurs électriques, notamment de tensions électriques et/ou de courants électriques, comprenant:
- un corps de boîtier comprenant un compartiment (2),
- au moins un dispositif de mesure placé ou formé dans le compartiment du boîtier pour mesurer une grandeur électrique mesurable au moyen de l'instrument de mesure (1), et
- un accumulateur d'énergie électrique (3), dans lequel le corps du boîtier (2) comporte au moins une zone d'absorption (4) pour l'absorption soluble du dispositif de stockage d'énergie électrique (3), dans laquelle la zone d'absorption (4) est conçue comme une cavité (5) dans le corps du boîtier (2), dans laquelle le dispositif de stockage d'énergie électrique (3) comprend un élément de raccordement électrique (16) constituant une partie d'un dispositif de raccordement électrique du côté du dispositif de stockage d'énergie (15) pour le raccordement électrique du dispositif de stockage d'énergie électrique (3) absorbé dans la zone d'absorption (4) à un élément de raccordement électrique (7) associé à un dispositif de raccordement électrique du côté du corps du boîtier (8) et l'élément de raccordement du côté du dispositif de stockage d'énergie (16) est conçu comme une approche supérieure à un corps de boîtier du côté du dispositif de stockage d'énergie (11),
**caractérisé en ce que:**
le dispositif de stockage d'énergie électrique (3) est équipé d'un autre élément de raccordement électrique par lequel ce dernier peut être relié à un câble de recharge ou à un dispositif similaire dans le cadre d'une opération de recharge, cet autre élément de raccordement étant placé ou formé dans la zone d'un côté d'un corps de boîtier côté accumulateur d'énergie (11) qui n'est pas accessible dans l'état du dispositif de stockage d'énergie (3) enregistré dans la zone de réception (4).

2. Appareil de mesure selon la revendication 1, **caractérisé en ce que** la zone d'enregistrement (4) est conçue comme une zone d'insertion dans laquelle un accumulateur d'énergie électrique (3) peut être inséré dans la zone d'enregistrement ou comme une zone d'insertion dans laquelle un accumulateur d'énergie électrique (3) peut être inséré dans la zone d'enregistrement (4).

3. Appareil de mesure selon l'une quelconque des revendications précédentes, **caractérisé en ce que** la zone de prise de vue (4), notamment en ce qui concerne les dimensions d'un accumulateur d'énergie électrique (3) à prendre en charge dans celui-ci, est dimensionnée de telle sorte qu'un accumulateur d'énergie électrique (3) pris en charge dans celui-ci est pris en charge de manière définitive à ras des sections de paroi du corps du boîtier (2) qui limitent la zone de prise de vue (4).

4. Appareil de mesure selon l'une quelconque des revendications précédentes, **caractérisé en ce que** la zone de prise de vue (4) présente une géométrie de section transversale, en particulier rectangulaire, de l'accumulateur d'énergie électrique (3) à prendre en charge dans celui-ci, de forme opposée, en particulier en forme de U.

5. Appareil de mesure selon l'une quelconque des revendications précédentes, **caractérisé en ce que** la zone de prise de vue (4) est formée dans la zone d'une face arrière ou inférieure du corps du boîtier (2).

6. Appareil de mesure selon l'une quelconque des revendications précédentes, **caractérisé par** un dispositif de guidage (10) pour le guidage mobile d'un accumulateur d'énergie électrique (3) reçu dans la zone de réception (4), au moins entre une première position de guidage, en particulier une position de guidage initiale, et une deuxième position de guidage, en particulier une position de guidage finale.

7. Appareil de mesure selon la revendication 6, **caractérisé en ce que l'appareil** de guidage (10) comprend au moins un premier élément de guidage (10a) disposé ou formé du côté du corps du boîtier et au moins un deuxième élément de guidage (10b) disposé ou formé du côté de l'accumulateur d'énergie, qui sont équipés pour interagir en formant le guidage mobile d'un accumulateur d'énergie électrique (3) absorbé dans la zone de réception (4).

8. Appareil de mesure selon l'une quelconque des revendications précédentes, **caractérisé par** un dispositif de sécurité (12) destiné à sécuriser un accumulateur d'énergie électrique (3) reçu dans la zone d'enregistrement (4), en particulier dans une position de guidage, contre un mouvement indésirable du accumulateur d'énergie électrique (3) provenant de la zone d'enregistrement (4).

9. Appareil de mesure selon la revendication 8, **caractérisé en ce que** le dispositif de fusible (12) comprend au moins un premier élément de fusible (12a) disposé ou formé du côté du corps du boîtier et au moins un deuxième élément de fusible (12b) disposé ou formé du côté des accumulateurs d'énergie, qui sont équipés pour interagir en formant la sécurité d'un accumulateur d'énergie électrique (3) absorbé dans la zone de réception (4).

10. Appareil de mesure selon l'une quelconque des revendications précédentes, **caractérisé en ce qu'au** moins un élément de raccordement électrique (7) constituant une partie d'un dispositif de raccordement électrique côté corps (8) est disposé ou formé dans la zone de réception (4) pour le raccordement électrique d'un accumulateur d'énergie électrique (3) absorbé dans la zone de réception (4).

11. Appareil de mesure selon la revendication 10, **caractérisé en ce que** l'élément de raccordement électrique (7) est disposé ou formé dans la zone d'une section de paroi (9) du corps du boîtier (2) délimitant la zone de prise (4).

12. Appareil de mesure selon la revendication 9 ou 10, **caractérisé en ce que** l'élément de raccordement électrique (7) est placé ou formé à l'intérieur d'une section de paroi (9) du corps du boîtier (2) délimitant la zone de prise (4), en particulier dans une section de paroi (9) du corps du boîtier (2) déplacée en arrière et formée par rapport à une section de paroi (9) délimitant la zone de prise (4).

13. Appareil de mesure selon l'une quelconque des revendications précédentes, **caractérisé par** une enveloppe de protection (17) qui peut être reliée ou reliée au corps du boîtier (2) et qui, à l'état relié au corps du boîtier (2), l'entoure au moins par sections, afin de protéger le corps du boîtier (2) contre les influences extérieures.
